# EUROPEAN PATENT SPECIFICATION

(11) **EP 3 708 403 B1**
(45) Date of publication and mention of the grant of the patent: **20.01.2021**
(21) Application number: 19162233.1
(22) Date of filing: 12.03.2019
(51) Int. Cl.: B60L 3/00, B60L 3/04, H02J 7/00

(54) **SOLID STATE SWITCH DRIVER CIRCUIT FOR A BATTERY SYSTEM**
FESTKÖRPERSCHALTERTREIBERSCHALTUNG FÜR EIN BATTERIESYSTEM
CIRCUIT DE COMMANDE DE COMMUTATEUR À SEMICONDUCTEURS POUR UN SYSTÈME DE BATTERIE

(43) Date of publication of application: 16.09.2020
(73) Proprietor: Samsung SDI Co., Ltd., Gyeonggi-do 17084 (KR)
(72) Inventor: Kurcik, Peter, 8505 Sankt Nikolai im Sausal (AT); Hofer, Maximilian, 8230 Hartberg (AT)
(74) Representative: Gulde & Partner

(56) References cited:
- EP-A1- 3 352 322
- EP-A2- 1 531 535
- US-A1- 2011 051 303
- US-A1- 2018 152 035
- Maxim Integrated: "DC-DC Conversion Without Inductors", Maxim Design Support, Technical Documents, Tutorials, Power-Supply Circuits, APP 725, 22 July 2009 (2009-07-22), pages 1-8, XP055623085, Retrieved from the Internet: URL:https://pdfserv.maximintegrated.com/en /an/AN725.pdf [retrieved on 2019-09-17]
- Toshiba: "MOSFET Gate Drive Circuit Application Note", , 26 July 2018 (2018-07-26), pages 1-22, XP055622261, Retrieved from the Internet: URL:https://toshiba.semicon-storage.com [retrieved on 2019-09-13]

## Description

### Field of the Invention

The present invention relates to a solid state switch, SSS, driver circuit for a battery system, particularly to a SSS driver circuit with an improved availability of switch driving capability as well as an improved reliability of shutting of the SSS in state of an emergency. Preferably, the SSS driver circuit according to the invention meets ASIL B requirements with respect to availability and ASIL C requirements with respect to shut of functionality. The present invention further relates to a battery system with the SSS driver circuit of the invention.

### Technological Background

In the recent years, vehicles for transportation of goods and peoples have been developed using electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator. Furthermore, the vehicle may include a combination of electric motor and conventional combustion engine. In general, an electric-vehicle battery (EVB) or traction battery is a battery used to power the propulsion of battery electric vehicles (BEVs).

Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of unit battery cells coupled in series and/or in parallel so as to provide a high energy density, in particular for motor driving of a hybrid vehicle. That is, the battery module is formed by interconnecting the electrode terminals of the plurality of unit battery cells depending on a required amount of power and in order to realize a high-power rechargeable battery.

A battery pack is a set of any number of (preferably identical) battery modules. They may be configured in a series, parallel or a mixture of both to deliver the desired voltage, capacity, or power density. Components of battery packs include the individual battery modules, and the interconnects, which provide electrical conductivity between them.

For meeting the dynamic power demands of various electrical consumers connected to the battery system a static control of battery power output and charging is not sufficient. Thus, steady or intermittent exchange of information between the battery system and the controllers of the electrical consumers is required. This information includes the battery systems actual state of charge (SoC), potential electrical performance, charging ability and internal resistance as well as actual or predicted power demands or surpluses of the consumers.

For monitoring, controlling and/or setting of the aforementioned parameters a battery system usually comprises a battery management unit (BMU), a battery management system (BMS), and/or a battery system manager (BSM). Each of these control units may be realized as an integrated circuit (IC), a microcontroller (µC), an application specific integrated circuit (ASIC), or the like. Control units may be an integral part of the battery system and disposed within a common housing or may be part of a remote control module communicating with the battery system via a suitable communication bus. In both cases, the control unit communicates with the electrical consumers via a suitable communication bus, e.g. a CAN or SPI interface.

Further, a battery system usually comprises a battery disconnect unit, BDU, configured for disconnecting the battery stack from a downstream load in an abnormal operation condition, such as e.g., over temperature, over current, over voltage, crash of an electric vehicle, or the like. The BDU often comprises at least one relay between a node of the battery stack, e.g. the high voltage node thereof, and a downstream load. However, due to construction space requirements, increased demands with respect to switching speed and energy conversation semiconductor-based solutions for BDUs become more and more preferred. However, such semiconductor-based switches, e.g., MOSFET switches, require specific driver circuits Such a driver circuit is disclosed in US patent application US2018/152035 A1 (Li Guoxing).

The driver circuit for such a MOSFET switch might be disposed on a separate circuit carrier or may share a circuit carrier with another control unit of the battery system, e.g., the BMS. In order to be integrable in an electric vehicle, the driver switch must fulfil the safety standards that apply to electric vehicles, such as e.g., ASIL A, ASIL, B, ASIL, C, etc. However, known driver stages for solid state power switches do not yet fulfil these safety standards and/or the realization of the known driver stages for solid state power switches is cost intensive.

It is thus an objective of the present invention, to provide a solid state switch, SSS, driver circuit for a battery system that can fulfil the safety standards that apply to electric vehicles and that can be realized in a cost-effective manner.

### Description of the Invention

The objective of the invention is solved and the disadvantages of the prior art are overcome or at least reduced by the subject-matter of the present invention, i.e., by a solid state switch driver circuit for a battery system and a battery system according to the appended claims.

A first aspect of the present disclosure relates to a solid state switch, SSS, driver circuit for controlling a solid state switch operated as high side switch between a battery cell stack and a load. The SSS driver circuit is preferably configured as hardware based circuit, i.e., does not comprise any programmed elements itself. By omitting programmed elements, the computation time of the SSS driver circuit is preferably increased. The SSS driver circuit is preferably connected to the solid state switch of the battery system. Further preferred, the SSS driver circuit receives and transmits signals to and from a microcontroller, e.g., a BMS. The SSS driver circuit of the invention comprises a voltage generation circuit, VGC, which is configured for receiving a supply voltage, V_{SUP}, via a first input node, i.e., comprises a first input node that receives V_{SUP} during the operation of the SSS driver circuit. The VGC is further configured for receiving an output voltage of the battery cell stack, GND_{Driver}, via a second input node, i.e., comprises a second node that receives GND_{Driver} during the operation of the SSS driver circuit. The VCG is further configured to receive a ground voltage, GND, via a first ground node, i.e., comprises a first ground node that receives GND during the operation of the SSS driver circuit. The VGC is further configured to receive a first control signal, PWM, via a first control node, i.e., comprises a first control note that selectively receives the first control signal during the operation of the SSS driver circuit. The VGC is further configured to generate a drive voltage, VCC_{Driver}, higher than V_{SUP} and GND_{Driver} and for outputting VCC_{Driver} to a first output node in dependence of the first control signal.

The VGC of the invention is thus configured to generate a voltage that is sufficient for setting the high side solid state switch of a battery system conductive. Such a voltage has to be higher than the voltage provided to the solid state switch from the battery cell stack. The VGC of the invention preferably derives such voltage from GND_{Driver} and V_{SUP}, wherein the latter is preferably smaller than GND_{Driver}. Preferably GND_{Driver} is also self-supplied by a battery system, the SSS driver circuit is utilized in. Particularly preferred, GND_{Driver} is provided to the SSS driver circuit by a system basis chip of the battery system, which is power supplied by the battery system. Further preferred, GND_{Driver} is between 10 V and 30 V, preferably between 15 V and 25 V and particularly preferred is 20 V. Further preferred, VCC_{Driver} roughly equals the sum of V_{SUP} and GND_{Driver}, e.g., VCC_{Driver}∼68V with V_{SUP}∼20V and GND_{Driver}∼48V.

Further preferred, a SSS, to which the driver circuit is connected to, comprises at least one power MOSFET that is realized as a high side switch in the battery system, preferably a 48 V battery system. For steering the gate voltage of the MOSFET, a non-grounded voltage domain is needed. This steering voltage is provided by the VGC as VCC_{Driver} in a cost - effective manner, e.g., without the need for a transformer. The first control signal preferably is a PWM signal, e.g., a square wave signal alternately taking the value of "0" and "1" or the like. Based on this signal, VCC_{Driver} is generated by the VGC acting as a DCDC converter. In other words, the amplitude of VCC_{Driver} is preferably set via the duty cycle of the PWM signal. Further preferred, VCC_{Driver} is output by the VGC continuously as long as the first control signal is applied to the VGC and is not output if no first control signal is applied to the VGC.

The SSS driver circuit of the invention further comprises a switch off circuit, SOC, that is configured for receiving the output voltage GND_{Driver} via a third input node, i.e., comprises a third input node that receives GND_{Driver} during the operation of the SSS driver circuit. The SOC is further configured for receiving a ground voltage, GND, via a second ground node, i.e., comprises a second ground note that receives GND during the operation of the SSS driver circuit. The SOC is further configured to receive a second control signal, OFF1, via a second control node, i.e., comprises a second control node that selectively receives OFF1 during the operation of the SSS driver circuit. The SOC is further configured to receive a third control signal, OFF2, via a third control node, i.e., comprises a third control node that selectively receives OFF2 during the operation of the SSS driver circuit.

The SOC is further configured for outputting, GND_{Driver}, to a second output node in dependence of the second and third control signals. As shown in more detail below, the SOC is configured for providing a signal, e.g., GND_{Driver}, which is suitable for setting the SSS, to which the driver circuit is connected, nonconductive. Hence, by outputting GND_{Driver} in dependence of the second and third control signals, OFF1 and OFF2, redundancy in providing the shut off signal GND_{Driver} is realized. Particularly preferred, the GND_{Driver} is outputted to the second output node if one of the second and third control signals, OFF1 and OFF2, takes a specific value. In other words, GND_{Driver} is not output continuously from SOC. The SOC of the SSS driver circuit of the invention is thus advantageously configured to output at least one of the shut off signals OFF1 and OFF2 reliably and fast.

The SSS driver circuit of the invention further comprises a switch controller, i.e., a switch controller circuit, which is connected to the first output node of the VGC and to the second output node of the SOC. The switch controller is further configured for receiving a ground voltage, GND, via a third ground node, i.e., comprises a third ground node that receives GND during the operation of the SSS driver circuit. The switch controller is further configured to receive a fourth control signal, ON1, via a fourth control node, i.e., comprises a fourth control node that selectively receives ON1 during the operation of the SSS driver circuit. The switch controller is configured for forwarding, i.e., outputting, one of the voltages, VCC_{Driver}, and GND_{Driver}, to a gate node of the solid state switch in in dependence of the fourth control signal.

The switch controller of the SSS driver circuit is thus configured to receive the VCC_{Driver} as high side switching signal suitable for setting the SSS, to which the SSS driver circuit is connected to, conductive. The switch controller of the SSS driver circuit is further configured to receive GND_{Driver} as switching signal suitable for setting the SSS, to which the SSS driver circuit is connected to, nonconductive. Further, depending on a value of the fourth control signal, the switch controller either connects or disconnects the first output node and a gate node of the solid state switch, e.g., to the gates of MOSFETS thereof. Further, depending on the value of the fourth control signal, the switch controller forwards the voltage present at the second output node, e.g., GND_{Driver}, to a gate node of the solid state switch, e.g., to the gates of MOSFETS thereof. Preferably, the switch controller outputs one of VCC_{Driver} or GND_{Driver} to an output node thereof, depending on the value of the fourth control signal. Particularly preferred, the switch controller actively switches solely VCC_{Driver} to the gate node in dependence of ON1, wherein the voltage at the second output node, e.g. GND_{Driver} (which is always lower than VCC_{Driver}) is elsewise connected to the gate node in a passive manner. Therein, whether or not GND_{Driver} is applied to the second output node depends on the second and third control signals OFF1 and OFF2 as described above.

According to a preferred embodiment of the solid state switch, SSS, driver circuit of the invention, the voltage generation circuit comprises a first capacitor with a first capacitor node connected to the first input node via a first diode and with a second capacitor node connected to either the first ground node or to the second input node in dependence of the first control signal. The first capacitor node is preferably connected to the cathode of the first diode and the anode of the first diode is connected to the first input node. Further preferred, switches are interconnected between the second capacitor node and the first ground node and the second input node, respectively. Thus, the potential of one of these nodes can be selectively applied to the second capacitor node in dependence of the states of these switches.

Particularly preferred, during operation of the SSS driver circuit, the second capacitor node is first connected to the first ground node and the first capacitor is thus charged with V_{SUP} applied to the fist supply node via the first diode. Subsequently, the second capacitor node is connected to the second input node and hence put on GND_{Driver} potential. As the voltage drop over the first capacitor has to be maintained, the first capacitor node is thus shifted up by the difference of (GND_{Driver}-GND), i.e., usually by GND_{Driver}. In other words, in the SSS driver circuit of the invention, a flying cap is used for shifting the voltage level for switch control. The first capacitor is thus advantageously operated as a flying capacitor with suitable capacity.

In a particularly preferred embodiment, the voltage generation circuit comprises a first switch that is configured to connect the second capacitor node to the first ground node in response to the first control signal having a first value and a second switch that is configured to connected the second capacitor node to the second input node in response to the first control signal having a second value. Exemplarily, the first value may be a high value, e.g., "1", of the square wave PWM first control signal and the second value may be a low value, e.g., "0", of the square wave PWM first control signal. Exemplarily, the first switch might be configured as a first MOSFET, T₁, particularly as an n-channel MOSFET having a gate node directly connected to the first control node. Further, the second switch might be configured as a second MOSFET, T₂, particularly a p-channel MOSFET having a gate node connected to the first control node via an inverter. However, also the first switch might be a p-channel MOSFET and the second switch may be an n-channel MOSFET and/or the first control signal might be used with reversed polarity. Also other circuit configurations using more than one transistor for the first switch and/or the second switch are preferred. Preferably, second switch is conductive when first switch is non-conductive and vice versa.

In another preferred embodiment of the solid state switch, SSS, driver circuit of the invention, the voltage generation circuit comprises a Zener diode that is interconnected in parallel to the first capacitor in between the first output node and the second input node. Preferably, a cathode of the Zener diode is connected to the first capacitor node of the first capacitor via a second diode. Therein, the cathode of the second diode is connected to the cathode of the Zener diode and the anode of the second diode is connected to the first capacitor node. Further preferred, an anode of the Zener diode is interconnected between the second input node and the second capacitor node of the first capacitor. Particularly preferred, the second switch as described above is interconnected between the anode of the Zener diode and the second capacitor node of the first diode. The Zener diode is advantageously configured as a protection diode that is configured for ensuring that the VCC_{Driver} is limited to a certain voltage. Preferably, the Zener diode is configured for limiting VCC_{Driver} to a voltage of about 20 V.

Further preferred, the voltage generation circuit comprises a second capacitor that is interconnected in parallel to the first capacitor in between first output node and second input node. The second capacitor is preferably also connected in parallel to the Zener diode. Preferably, the second capacitor comprises a first capacitor node that is connected to the first output node and particularly preferred is interconnected between the first output node and the cathode of the Zener diode. Further preferred, the Zener diode comprises a second capacitor node that is connected to the second input node, particularly preferred is interconnected between the second input node and the anode of the Zener diode. In a preferred embodiment, when the second switch is set conductive and the first switch is set non-conductive (i.e., when the first capacitor node of the first capacitor is shifted to VCC_{Driver}), the second capacitor is charged with the voltage at the first capacitor node via the second diode.

Hence, the second capacitor is charged with VCC_{Driver} and thus advantageously stores the energy to set the SSS conductive. Hence, even if the voltage generation by the VGC of the SSS driver circuit is impaired, there is sufficient energy stored in the second capacitor. The second capacitor is thus advantageously configured to keep the SSS to stay conductive for a given time (i.e., depending on the capacity of the second capacitor) to provide a "limp home" functionality to an electric vehicle provided with a battery system having the SSS driver circuit of the invention. In order to meet an ASIL B standard for such an electric vehicle, the second capacitor preferably has a capacity that is chosen such that the SSS can be maintained conductive for a minimal duration in between 35 s and 1 min.

In a further preferred embodiment of the SSS driver circuit of the invention, the switch controller as described above further comprises a third switch that is configured to connect the first output node to the gate node (i.e., a corresponding output node of the switch driver) in response to the fourth control signal having a first value and to disconnect the first output node from the gate node in response to the fourth control signal having a second value. In other words, the third switch forwards VCC_{Driver} to the gate node in response to the fourth control signal having a first value. Further preferred, the gate node is connected directly to the second output node. Hence, if VCC_{Driver} is not forwarded to the gate node, the potential that applies to the second output node is also applied to the gate node. The potential at the second output node preferably is either floating or GND_{Driver} as set forth in more detail below.

Particularly preferred, the third switch is a third MOSFET, T₃, preferably a p-channel MOSFET with a source node connected to the first output node and a drain node connected to the second output node. In this embodiment, the switch controller further comprises a fourth switch that is configured to connect a gate node of the third MOSFET to the third ground node, i.e., GND, in response to the fourth control signal having a first value and to disconnect the gate node of the third MOSFET from the third ground node in response to the fourth control signal having a second value. Further preferred, the fourth switch is a fourth MOSFET, T₄, preferably an n-channel MOSFET with a source node connected to the third ground node, i.e., GND, the drain node connected to the gate node of the third MOSFET. Then the fourth control signal is applied to the gate node of the fourth MOSFET and the first value is a high value, e.g., "1" or VDD, and the second value is a low value, e.g., "0" or GND.

In a further preferred embodiment of the solid state switch, SSS, driver circuit of the invention, the switch off circuit comprises a fifth switch that is configured to connect the third input node to the second output node in response to the second control signal having a first value and to disconnect the third input node from the second output node in response to the second control signal having a second value. In this embodiment, the switch off circuit further preferably comprises a seventh switch that is configured to connect the third input node to the second output node in response to the third control signal having a first value and to disconnect the third input node from the second output node in response to the third control signal having a second value. Hence, redundancy in selectively connecting the third input node, i.e., GND_{Driver}, to the second output node is provided by the fifth and seventh switches.

Particularly preferred, the fifth switch is a fifth MOSFET, T₅, particularly a p-channel MOSFET with a source node connected to the second output node and a drain node connected to the third input node. In this preferred embodiment, the switch off circuit further comprises a sixth switch that is configured to connect a gate node of the fifth MOSFET to the second ground node in response to the second control signal having a first value and to disconnect the gate node of the fifth MOSFET from the second ground node in response to the second control signal having a second value. Particularly preferred, the sixth switch is a sixth MOSFET, T₆, particularly an n-channel MOSFET with a source node connected to the second ground node, i.e., GND, and a drain node connected to the gate node of the fifth MOSFET. Then the second control signal is provided to the gate node of the fifth MOSFET and the first value is a high signal, e.g., "1" or VDD, and the second value is a low value, e.g., "0" or GND, VSS.

Further preferred, the seventh switch is a seventh MOSFET, T₇, particularly a p-channel MOSFET with a source node connected to the second output node and a drain node connected to the third input node. In this embodiment, the switch off circuit further comprises a ninth switch that is configured to connect a gate node of the seventh MOSFET to the second ground node in response to the third control signal having a first value and to disconnect the gate node of the seventh MOSFET from the second ground node in response to the third control signal having a second value. Preferably, the ninth switch is a ninth MOSFET, T₉, particularly an n-channel MOSFET with a source node connected to the second ground node and a drain node connected to the gate node of the seventh MOSFET. Then the second control signal is provided to the gate node of the ninth MOSFET and the first value is a high signal, e.g., "1" or VDD, and the second value is a low value, e.g., "0" or GND, VSS.

According to another preferred embodiment, the solid state switch, SSS, driver circuit of the invention further comprises a first diagnostic circuit that configured to output a first diagnostic signal, DIAG₁, indicating a potential at the second input node and to output a second diagnostic signal, DIAG2, indicating a potential at the first output node. Particularly preferred, the first diagnostic circuit comprises a first voltage divider with a first divider node connected to the second input node and a second diver node connected to the first ground node (GND).

An output node of the first voltage divider then provides the first diagnostic signal. Further preferred, the first diagnostic circuit comprises a second voltage divider with a first divider node connected to the first output node and a second diver node also connected to GND. An output node of the second voltage divider then provides the second diagnostic signal. The first diagnostic circuit thus advantageously provides first and second diagnostic signals that are indicative of the voltage drop over the second capacitor as described above. Hence, the first diagnostic circuit allows detecting malfunctions in the battery system, as the first diagnostic circuit receives the same voltage, GND_{Driver}, as applied to the input of the SSS. The first diagnostic circuit further allows testing of the fifth switch and the seventh switch.

In a further preferred embodiment, the SSS driver circuit of the invention comprises a second diagnostic circuit that is configured to output a third diagnostic signal, DIAG₃, indicating a potential at the second output node. Particularly, the second diagnostic circuit is configured to output a third diagnostic signal, DIAG₃, indicating a potential at the drain node of the third switch MOSFET T3. Preferably, the second diagnostic circuit comprises a third voltage divider with a first divider node connected in between the second output node and the drain node of the third switch MOSFET T3 and a second divider node connected to ground, GND. The second diagnostic circuit allows for testing the functionality of the third switch described above, particularly while operating the voltage generation circuit with a PWM signal configured for outputting a voltage via the first output node that is lower than VCC_{Driver}.

Another aspect of the invention relates to a battery system, particularly to a battery system for an electric vehicle, such as e.g. a high voltage battery system for enabling electric driving of an electric vehicle. The battery system preferably comprises a battery cell stack comprising a plurality of battery cells and being configured for supplying an output voltage, GND_{Driver}, to a stack node. Preferably, the battery cell stack comprises a plurality of battery cells interconnected in parallel and/or in series between a ground node and the stack node. Further preferred, the battery cell stack is configured for providing a voltage of 48 V. The battery system of the invention further comprises a solid state switch, SSS, that is interconnected between the stack node and a supply node. The SSS preferably is a solid state power switch such as e.g., a MOSFET power switch. The solid state switch comprises at least one set of anti-serially interconnected FETs, each set comprising at least one first FET, T_{A}, and at least one second FET, T_{B}. Therein, the gate contacts of the FETs are electrically interconnected and the source contacts of the FETs are electrically interconnected. Further, at least one first drain contact of the at least one first FET is electrically connected to the stack node and at least one second drain contact of the at least one second FET is electrically connected to the supply node. The battery system of the invention further comprises the solid state switch driver circuit according to the invention as described above, wherein the interconnected gate contacts of the FETs are connected to the gate node. In other words, the output node of the switch driver of the SSS driver circuit as described above is connected to the gate node, i.e., the interconnected gates of the SSS. Hence, the output signal of the SSS driver circuit selectively sets the MOSFETS of the SSS either conductive or nonconductive in dependence of the control signals, ON1, OFF1, OFF2.

In a preferred embodiment of the invention, the supply voltage, V_{SUP}, which applies to the first input node of the SSS driver circuit of the invention, is supplied by the battery cell stack of the battery system. In other words, the SSS driver circuit is self-supplied by the battery system, the power output of which it controls via the SSS. Particularly preferred, the SSS driver circuit is supplied by a system basis chip of the battery system, wherein the system basis chip receives its supply voltage from the battery cell stack of the battery system. The system basis chip preferably comprises one or more further functions with respect to the battery system, such as e.g., voltage control, reset function, watchdog function, wake up function, etc.

In a further preferred embodiment, the battery system of the invention further comprises a microcontroller that is configured to operate the SSS driver circuit of the invention. Particularly preferred, the microcontroller is configured to receive at least one signal indicative of an operation state of the battery system. The at least one signal indicative of an operation state of the battery system preferably comprises a voltage signal, a current signal, a temperature signal, a crash indication signal, or the like. The current signal is preferably obtained by a shunt resistor that is connected downstream of the stack node of the battery cell stack. The microcontroller is further configured to determine, based on the at least one signal indicative of an operation state of the battery system, to determine the presence of an abnormal operation state of the battery system, such as e.g., an overcurrent, a thermal runaway, a crash of the vehicle, etc. The microcontroller is further configured to generate and output each of the first control signal, the second control signal and the third control signal as described above in dependence of the determined operation state of the battery system. Particularly preferred, the microcontroller is configured to control, via the second and third control signal, the conductivity state of SSS set by the SSS driver circuit. Further preferred, the microcontroller is configured to control, via the second control signal, the amplitude of the VCC_{Driver} voltage generated by the voltage generation circuit. Above that, the microcontroller is preferably configured to perform at least one other control function with respect to the battery system. Preferably, the microcontroller is at the same time configured as BMS/BSM and is configured to perform cell balancing, voltage and/or current measurements or the like.

In another preferred embodiment of the battery system, the microcontroller is further configured to receive at least one of the first diagnostic signal, the second diagnostic signal, and the third diagnostic signal. Preferably, the microcontroller is further configured to determine, based on this at least one diagnostic signal, the operability of the SSS driver circuit and or the operation state of the battery system. In detail, the microcontroller is configured to determine whether or not a failure is present in the battery system based on the first and second diagnostic signals that indicate the voltage gap over the second capacitor. Further preferred, the microcontroller is configured to determine the operability of the third switch, the fifth switch and/or the seventh switch based on the third diagnostic signal and the specific test procedure performed using the second diagnostic circuit.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may comprise metallization, e.g. surface metallizations and/or pins, and/or may comprise conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media, e.g. a CD, flash drive, or the like.

Also, a person of skill in the art should recognize that the functionality of various computing devices may be combined or integrated into a single computing device, or the functionality of a particular computing device may be distributed across one or more other computing devices without departing from the scope of the embodiments of the present invention.

Further aspects of the present invention are disclosed in the dependent claims or the following description of the drawings.

### Brief Description of the Drawings

Features will become apparent to those of ordinary skill in the art by describing in detail exemplary embodiments with reference to the attached drawings in which:
- Figure 1: schematically illustrates a solid state switch driver circuit according to a first embodiment;
- Figure 2: schematically illustrates a solid state switch driver circuit according to a second embodiment;
- Figure 3: schematically illustrates a solid state switch driver circuit according to a third embodiment;
- Figure 4: schematically illustrates a solid state switch driver circuit according to a fourth embodiment; and
- Figure 5: schematically illustrates a solid state switch driver circuit according to a fifth embodiment.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art.

Accordingly, processes, elements, and techniques that are not considered necessary to those having ordinary skill in the art for a complete understanding of the aspects and features of the present invention may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present invention refers to "one or more embodiments of the present invention." In the following description of embodiments of the present invention, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

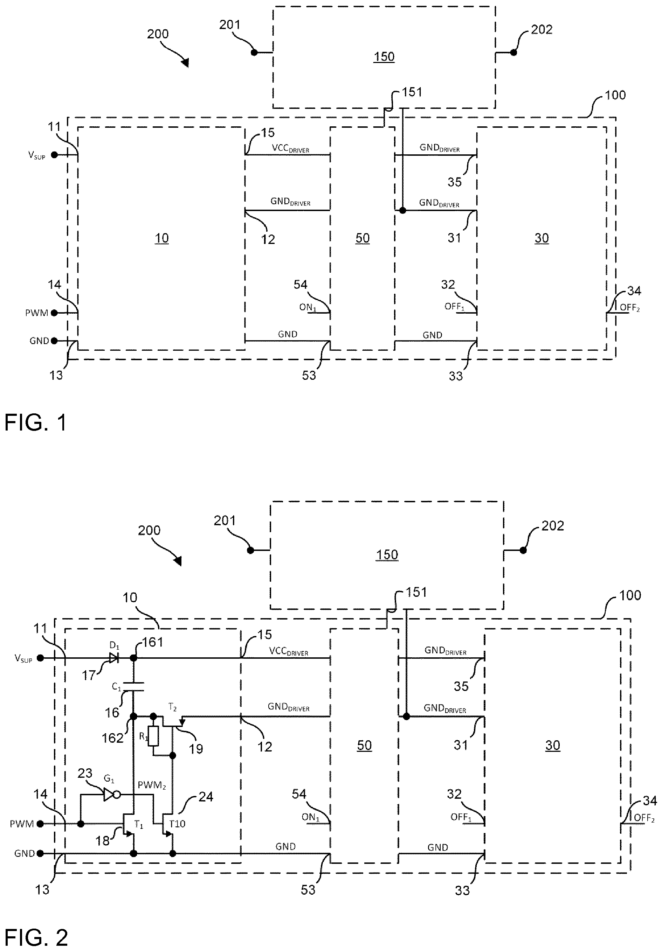

Figure 1 schematically illustrates a solid state switch, SSS, driver circuit 100 according to a first embodiment of the present invention. The SSS driver circuit 100 is configured for controlling a solid state switch, SSS, 150, interconnected between a stack node 201 and a supply node 202. Therein, the stack node 201 is connected to a battery cell stack that provides an output voltage of the battery cell stack, e.g., 48 V, to the stack node 201. The supply node 202 is configured to be connected to one or more loads or a load circuit for supplying power to the one or more loads. The SSS 150 is configured to selectively connect or disconnect the stack node 201 and the supply node 202. Particularly, the SSS 150 shall enable to disconnect the battery cell stack from any load in an abnormal operation condition.

The SSS 150 is operated as a high side switch between the stack and the supply node 202.

The SSS driver circuit 100 of the first embodiment is configured to output a control signal to the SSS 150, particularly to a gate node 151 of the SSS 150. The control signal is output to the gate node via an output node of the SSS driver circuit 100 that corresponds to the gate node 151. However, in the following it is solely referred to the gate node 151. The control signal output by the SSS driver circuit 100 to the SSS 150 is for selectively setting the SSS 150 conductive or non-conductive and is generated as explained in the following.

The SSS driver circuit 100 as shown in Figure 1 comprises a voltage generation circuit 10, a shut off circuit 30 and a switch controller 50. These sub-circuits of the SSS driver circuit 100 realize different functionalities in the SSS driver circuit and are characterized by their respective inputs and outputs as follows. The voltage generation circuit, VGC, 10 comprises a first input node that receives a supply voltage, V_{SUP}, which is supplied indirectly by the battery cell stack, preferably by a system basis chip of a battery system comprising the battery cells. The VGC 10 further comprises a second input node 12 that receives an output voltage of the battery cell stack, in the following referred to as GND_{Driver}. The VGC 10 further comprises a first ground node 13 for receiving a ground voltage, GND. The ground voltage GND preferably is a common ground of the SSS driver circuit 100, the stack and the battery system.

The VGC 10 is configured for generating a drive voltage VCC_{Driver} using the supply voltage V_{SUP} and the output voltage GND_{Driver}. Therein the drive voltage is higher than V_{SUP} as well as higher than GND_{Driver}. Further, GND_{Driver} is higher than V_{SUP}, preferably V_{SUP} is about 20 V and GND_{Driver} is about 48 V. The drive voltage VCC_{Driver} is suitable for setting the SSS 150 conductive when it is applied to the gate node 151 of the SSS 150. In the VGC 10, the drive voltage VCC_{Driver} is generated in dependence of a first control signal. The first control signal is applied to the VGC 10 via a first control node 14 and preferably is a pulse-width-modulating, PWM, signal. The duty cycle of the PWM signal received via the first control node 14 preferably controls the amplitude of the drive voltage VCC_{Driver}. In other words, the VGC 10 operates as a DCDC converter the conversion ratio of which is controlled via the first control signal. The drive voltage VCC_{Driver} is output to a first output node 15 of the VGC 10. Preferably, the drive voltage VCC_{Driver} is output continuously to the first output node 15. Summarized, the function of the VGC 10 is to generate a voltage that is high enough to set conductive a high side SSS 150 interconnected between a battery stack and a load from a voltage provided by that battery stack, i.e., performs a voltage up conversion operation.

The SSS driver circuit 100 of the invention further comprises a switch off circuit, SOC, 30 that comprises a third input node that also receives the output voltage GND_{Driver}. The SOC 30 further comprises a second ground node that also receives the ground voltage, GND. Further, the SOC 30 comprises a second control node 32 that receives a second control signal OFF1 and further comprises a third control node 34 that receives a third control signal, OFF2. Therein, the second control signal and the third control signal are preferably binary signals, i.e., take one of two values, e.g., of a high value "1" and a low value "0". Therein, these values can be represented by specific voltages or specific currents. The SOC 30 is configured for outputting the output voltage GND_{Driver} to a second output node 35 in dependence of the second and third control signals. In other words, the SOC 30 is configured to output a voltage for setting non-conductive the high side SSS 150 in dependence of two signals, i.e., OFF1 and OFF2. Particularly, the SOC 30 is configured to output the GND_{Driver} if at least one of the two control signals OFF1 and OFF2 takes a specific value, e.g., a high value "1". Otherwise, the SOC 30 does not output the GND_{Driver} to the second output node 35 and hence the second output node 35 is floating. Therein, the output's dependency of the second control signal OFF1 and the third control signal OFF2 provides redundancy in setting the SSS 150 non-conductive and thus increases the operational safety of the SSS 150.

The SSS driver circuit 100 further comprises a switch controller 50, which is another subcircuit of the SSS driver circuit 100. The switch controller 50 is connected to the first output node 15 of the VGC 10 from which it receives the drive voltage VCC_{Driver} generated in dependence of the first control signal. The switch controller 50 is further connected to the second output node 35 of the shut off circuit 30 from which it receives the output voltage GND_{Driver} in dependence of the second and third control signal. The switch controller 50 further comprises a third ground node 53 that also receives the ground voltage GND. The switch controller 50 further comprises a fourth control node 54 that receives a fourth control signal ON1. Preferably, the fourth control signal is a binary signal, i.e., takes one of two values, e.g., either a high value "1" or a low value "0". Therein, these values can be represented by specific voltages or specific currents. The switch controller 50 is configured to forward one of the received voltages, VCC_{Driver}, and GND_{Driver}, to a gate node 151 of the solid state switch 150 via an output node of the switch controller 50 and in in dependence of the fourth control signal, ON1. In other words, if the fourth control signal takes a first value the switch controller 50 outputs VCC_{Driver} and when the fourth control signal takes a second value the switch controller 50 outputs GND_{Driver} or a floating voltage to the gate node 151.

The SSS driver circuit 100 of the invention allows the operation of a SSS 150 using solely voltages supplied within the battery system as well as a minimal set of control signals, while maintaining high functional safety during operation. Particularly, solely if ON1 is applied with a first value to switch controller 50, the VCC_{Driver} voltage is output to the gate node 151 and the SSS 150 is set conductive. Otherwise, the voltage present at the second output node 35 is directly forwarded to the gate node 151. Further, if at least one of OFF1 and OFF2 is applied with a certain value to SOC 30, the GND_{Driver} voltage is applied to the second output node 35 and, if ON1 takes a second value, to the gate node 151 and SSS 150 is set non-conductive. Hence, the SSS driver circuit 100 provides a cost-effective solution for controlling the SSS 150 without the need for e.g., a transformer for generating VCC_{Driver}, and with improved redundancy in setting non-conductive the SSS 150 based on the two signals OFF1, OFF2.

Figure 2 schematically illustrates a solid state switch driver circuit 100 according to a second embodiment. The basic configuration of the embodiment as illustrated in Figure 2 is identical to the embodiment as shown in Figure 1. Insofar, a repeated description is omitted and the same reference signs are used for the same components. However, the embodiment of Figure 2 is distinguished by the use of specific components as described in the following.

Particularly, VGC 10 of the SSS driver circuit 100 of Figure 2 comprises a first capacitor C1 16 with a first capacitor node 161 and a second capacitor node 162. The first capacitor node 161 is connected to the first input node 11 via a first diode 17, particularly the first capacitor node 161 is connected to the cathode of the first diode 17 and the cathode of the first diode 17 is connected to the first input node 11. The first capacitor node 161 is also connected to the first output node 15, i.e., is interconnected between the first output node 15 and the cathode of the first diode 17. The second capacitor node 162 is connected to ground node 13 via a first switch 18 and is connected to the second input node 12 via a second switch 19.

Particularly, the first switch 18 is a first MOSFET T₁ (n-channel) with a source node connected to the first ground node 13 and a drain node connected to the second capacitor node 162. The gate of the first MOSFET T₁ is connected to the first control node 14, i.e., receives the first control signal, PWM. Hence, if PWM takes a high value, e.g., "1" or VDD, the ground voltage GND is applied to the second capacitor node 162 via the first switch 18. Then, the first capacitor 16 is charged via the first diode 17 with V_{SUP} provided by the first input node 11 and hence a voltage drop between GND and V_{SUP} occurs over C1.

Further, second switch 19 is a second MOSFET T₂ (p-channel) with a source node connected to the second input node 12 and a drain node connected to second capacitor node 162. A gate node of second MOSFET T₂ is connected to first ground node 13 via another n-channel MOSFET T₁₀, a source node of which is connected to first ground node 13, a drain node of which is connected to the gate node of the second MOSFET T₂ and a gate node of which is connected to the first control node 14 via an inverter 23. Hence, if PWM takes a low value, e.g., "0" or VSS, the MOSFET T₁₀ is set conductive and connects the first ground node 13 with the gate node of second MOSFET T₂ and thus sets second MOSFET T₂ conductive. Then, the second input node 12 is connected to the second capacitor node 162 which is thus set to the potential GND_{Driver}. Due to the voltage drop over the charged first capacitor 16 C1 thus a voltage equal to the sum of V_{SUP} and GND_{Driver} applies to the first capacitor node 161. In other words, the VGC 10 operates as a DCDC converter with flying cap capacitor C1. Alternatively, also n-channel MOSFET could be used for second switch T₂, the gate of MOSFET T2 being then connected to the first control node 14 via the first converter 23.

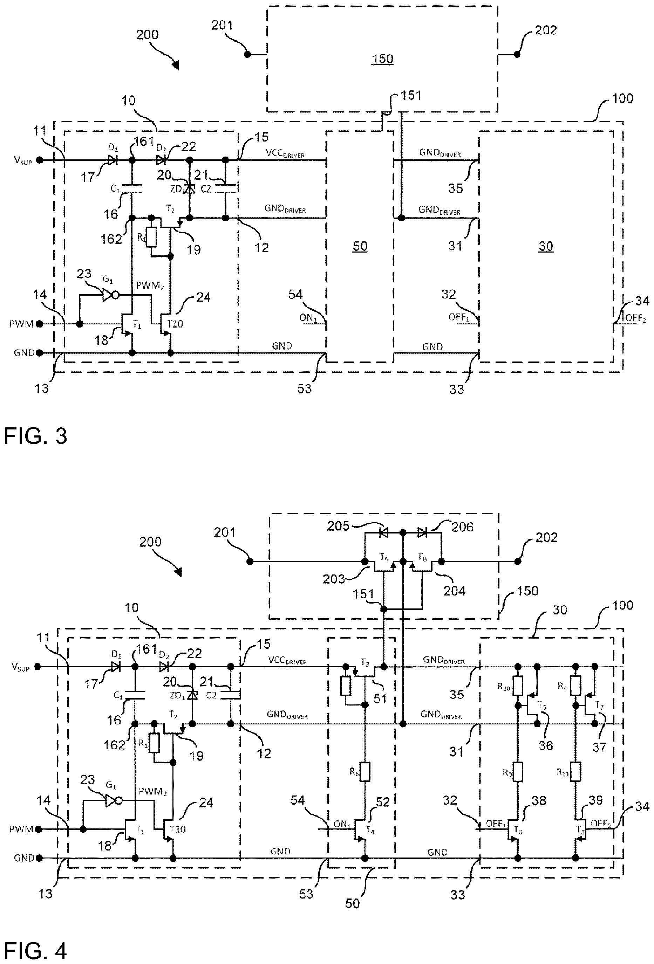

Figure 3 schematically illustrates a solid state switch driver circuit 100 according to a third embodiment. The basic configuration of the embodiment as illustrated in Figure 3 is identical to the embodiment as shown in Figures 1, 2. Insofar, a repeated description is omitted and the same reference signs are used for the same components. However, the embodiment of Figure 3 is distinguished by the use of specific components as described in the following.

Particularly, in the embodiment of Figure 3, the VGC 10 further comprises a Zener diode 20 that is interconnected in parallel to the first capacitor 16 in between the first output node 15 and the second input node 12. Particularly, the cathode of the Zener diode 20 is connected to a node that is interconnected between the first output node 15 and the first capacitor node 161 of the first capacitor 16. Further, the anode of the Zener diode 20 is connected to a node that is interconnected between the second switch 19 and the second input node 12. The Zener diode 20 functions as a protection diode that is configured for ensuring that the drive voltage VCC_{Driver} is limited to a certain value. Hence, the third switch T₃ is protected.

The VGC 10 of the third embodiment further comprises a second capacitor 21 that is interconnected in parallel to the first capacitor 16 in between the first output node 15 and the second input node 12. Particularly, a first capacitor node of the second capacitor 21 is interconnected between the first output node 15 and the node connected to the cathode of the Zener diode 20. Further, a second capacitor node of the second capacitor 21 is interconnected between the second input node 12 and the node connected to the anode of the Zener diode 20. During the operation of the VGC 10, the second capacitor 21 is charged with the voltage that applies to the first capacitor node 161 of the first capacitor 16 over the second diode 22. Hence, when the second switch is set conductive, the second capacitor 21 is charged with the drive voltage VCC_{Driver}, i.e., the first capacitor node of the second capacitor 21 is charged to the drive voltage VCC_{Driver}. Hence, the second capacitor 21 stores energy for setting the first output node 15 to VCC_{Driver} even if the voltage V_{SUP} or the first control signals PWM is not longer supplied to the VGC 10. Hence, the charged second capacitor 21 is configured to provide energy for setting SSS 150 conductive for a predetermined time period, preferably for a time period that allows fulfilling ASIL B requirements with respect to availability of the SSS 150, e.g., for a time of 35 s to 1 min.

Figure 4 schematically illustrates a solid state switch driver circuit 100 according to a fourth embodiment. The basic configuration of the embodiment as illustrated in Figure 4 is identical to the embodiment as shown in Figures 1 to 3. Insofar, a repeated description is omitted and the same reference signs are used for the same components. However, the embodiment of Figure 4 is distinguished by the use of specific components as described in the following.

In the fourth embodiment as illustrated in Figure 4, the solid state switch, SSS, 150 is specified to comprise at least one set of anti-serially interconnected FETs, wherein each set comprising at least one first FET, TA, 203 and at least one second FET, TB, 204. Therein, the gate contacts of the FETs 203, 204 are electrically interconnected and the source contacts of the FETs 203, 204 are electrically interconnected. Further, the drain contact(s) of the at least one first FET 203 is/are electrically connected to the stack node 201 and the drain contact(s) of the at least one second FET 204 is/are electrically connected to the supply node 202. In this configuration, both FETs 203, 204 can be controlled at once by applying a gate voltage to the gates of the FETs 203, 204 via the gate node 151. Further, the SSS 150 comprises a first flyback diode 205 connected in parallel with the first FET 203 and a second flyback diode 206 connected in parallel with the second FET 204, these diodes protecting the FETs 203, 204.

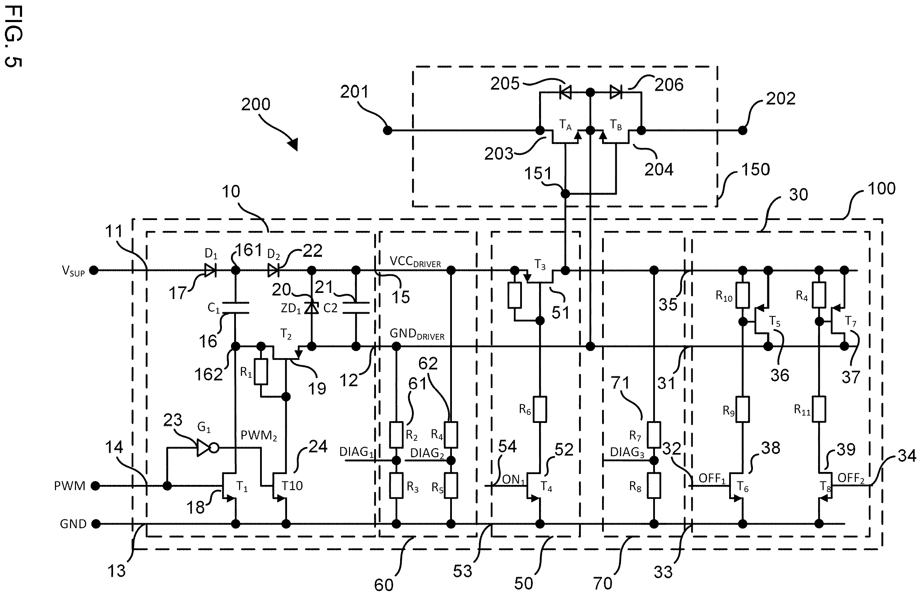

Further, in Figure 5 it is specified that the SOC 30 comprises a fifth switch 36 that is a fifth p-channel MOSFET T₅ with a drain node connected to the third input node 31, i.e., receiving GND_{Driver}, and a drain node connected to the second output node 35. A gate node of MOSFET T₅ is connected to the second ground node 33 via a sixth switch 38 that is a sixth n-channel MOSFET T₆. Particularly, the source node of MOSFET T₆ is connected to the second ground node 33, the drain node of MOSFET T₆ is connected to the gate node of MOSFET T₅ and a gate node of MOSFET T₆ is connected to the second control node 32. That is, if the second control signal OFF1 takes a high value, e.g., "1" or VDD, MOSFET T₆ is set conductive and applies ground voltage GND to the gate node of MOSFET T₅. Hence, the gate channel of MOSFET T₅ is set conductive and the cell stack's output voltage GND_{Driver} is applied to the second output node and to the gate node 151 of the SSS 150, thus setting the FETs 203 ,204 non-conductive, hence disconnecting stack node 201 from supply node 202.

Further, in Figure 5 it is specified that the SOC 30 comprises a seventh switch 37 that is a seventh p-channel MOSFET T₇ with a drain node connected to the third input node 31, i.e., receiving GND_{Driver}, and a drain node connected to the second output node 35. A gate node of MOSFET T₇ is connected to the second ground node 33 via an eighth switch 39 that is a eighth n-channel MOSFET T₈. Particularly, the source node of MOSFET T₈ is connected to the second ground node 33, the drain node of MOSFET T₈ is connected to the gate node of MOSFET T₇ and a gate node of MOSFET T₈ is connected to the third control node 34. That is, if the third control signal OFF2 takes a high value, e.g., "1" or VDD, MOSFET T₈ is set conductive and applies ground voltage GND to the gate node of MOSFET T₇. Hence, the gate channel of MOSFET T₇ is set conductive and the cell stack's output voltage GND_{Driver} is applied to the second output node and to the gate node 151 of the SSS 150, thus setting the FETs 203, 204 non-conductive, hence disconnecting stack node 201 from supply node 202.

Further, in Figure 5 it is specified that the switch controller 50 comprises a third switch 51 that is a third p-channel MOSFET T₃ a source node of which is connected to the first output node 15 and a drain node of which is connected to the gate node 151, i.e., to a node interconnected between the gate node 151 and the second output node 35. That is, a voltage applied to the drain node of MOSFET T₃ is applied to gate node 151 insofar it is higher than the voltage that applies to the second output node 35. The gate node of the MOSFET T₃ is connected to the third ground node 53 via a fourth switch 52 that is a fourth n-channel MOSFET T₄. The source node of MOSFET T₄ is connected to the third ground node 53, the drain node of the MOSFET T₄ is connected to the gate node of MOSFET T₃ and the gate node of MOSFET T₄ is connected to the fourth control node 54, i.e., receives fourth control signal ON1. That is, if the fourth control signal ON1 takes a high value, e.g., "1" or VDD, MOSFET T₄ is set conductive and applies ground voltage GND to the gate node of MOSFET T₃. Hence, the gate channel of MOSFET T₃ is set conductive and the voltage at the first output node 15 is applied to the gate node 151 of SSS 150 setting FETs 203, 204 conductive.

Figure 5 schematically illustrates a solid state switch driver circuit 100 according to a fifth embodiment. The basic configuration of the embodiment as illustrated in Figure 5 is identical to the embodiment as shown in Figures 1 to 4. Insofar, a repeated description is omitted and the same reference signs are used for the same components. However, the embodiment of Figure 5 is distinguished by the use of specific components as described in the following.

In the fifth embodiment as illustrated in Figure 5, the SSS driver circuit 100 further comprises a first diagnostic circuit 60 that is configured to output a first diagnostic signal, DIAG₁, indicating a potential at the second input node 12 and to output a second diagnostic signal, DIAG2, indicating a potential at the first output node 15. Particularly, the first diagnostic circuit 60 comprises a first voltage divider 61 with a first divider node connected to the second input node 12 and a second diver node connected to the first ground node 13. An output node of the first voltage divider 61 then provides the first diagnostic signal DIAG1. Further, the first diagnostic circuit 60 comprises a second voltage divider 62 with a first divider node connected to the first output node 15 and a second diver node also connected to first ground node 13. An output node of the second voltage divider 62 then provides the second diagnostic signal DIAG2. The first diagnostic circuit 60 thus provides diagnostic signals that are indicative of the voltage drop over the second capacitor 21 as described above.

Hence, the first diagnostic circuit 60 allows detecting malfunctions in the battery system 200, as the first diagnostic circuit 60 receives the same voltage, GND_{Driver}, as applied to the input of the SSS. The first diagnostic circuit further allows testing of the fifth switch T₅ and the seventh switch T₇. Particularly, if T₃ is switched on, the switching off functionality of T₇ and T₉ can be diagnosed: Therefore, the drive voltage VCC_{Driver} is generated with a voltage that is lower than V_{TH} of the power MOSFETs 203, 204. Then, the functionality of T₅ and T₇ is tested individually by setting OFF1 and OFF2 to high signal individually and detecting the voltage with the first voltage divider 61, while third switch T₃ is set conductive via ON1. Therein, as VCC_{Driver} is controlled to be less than V_{TH} of FETs 203, 204 the SSS 150 is not closed. By the same approach, also the functionality of third switch T₃ can be tested by detecting DIAG 1 and comparing it to the signal DIAG2 representative of the voltage at first output node 15.

In the fifth embodiment as illustrated in Figure 5, the SSS driver circuit 100 further comprises a second diagnostic circuit 70 that is configured to output a third diagnostic signal, DIAG₃, which is indicating a potential at the second output node 35. Particularly, the second diagnostic circuit 70 is configured to output a third diagnostic signal, DIAG₃, indicating a potential at the drain node of the third switch MOSFET T₃ or more precisely the voltage at a node interconnected between the drain node of MOSFET T₃ and the second output node 35. The second diagnostic circuit 70 comprises a third voltage divider 71 with a first divider node connected in between the second output node 35 and the drain node of the third switch MOSFET T₃ and a second divider node connected to ground, GND. The second diagnostic circuit 70 allows for testing the functionality of the switches T₃ also while operating the voltage generation circuit 10 with a PWM signal that leads to an output voltage at the first output node that is less than the V_{TH} of the power FETs 203, 204. The second diagnostic circuit may be further used for testing the switching off capability of the fifth and seventh switches T₅, T₇.

### Reference signs

- 100: solid state switch driver circuit
- 10: voltage generation circuit
- 11: first input node
- 12: second input node
- 13: first ground node
- 14: first control node
- 15: first output
- 16: first capacitor
- 161: first capacitor node
- 162: second capacitor node
- 17: first diode
- 18: first switch
- 19: second switch
- 20: Zener diode
- 21: second capacitor
- 22: second diode
- 23: inverter
- 30: switch off circuit
- 31: third input node
- 32: second control node
- 33: second ground node
- 34: third control node
- 35: second output node
- 36: fifth switch
- 37: seventh switch
- 38: sixth switch
- 39: eighth switch
- 50: switch controller
- 51: third switch
- 52: fourth switch
- 53: third ground node
- 54: fourth control node
- 150: solid state switch
- 151: gate node
- 200: battery system
- 201: stack node
- 202: supply node
- 203: first FET(s)
- 204: second FET(s)
- 205: first free wheeling diode
- 206: second free wheeling diode

## Claims

1. Solid state switch, SSS, driver circuit (100) for controlling a solid state switch (150) operated as high side switch between a battery cell stack and a load, comprising:
a voltage generation circuit (10) configured for receiving an supply voltage, V_{SUP}, via a first input node (11), an output voltage of the battery cell stack, GND_{Driver}, via a second input node (12), a ground voltage, GND, via a first ground node (13) and a first control signal, PWM, and being configured for generating a drive voltage, VCC_{Driver}, higher than V_{SUP} and GND_{Driver} in dependence of the first control signal and for outputting VCC_{Driver} to a first output node (15),
a switch off circuit (30) configured for receiving the output voltage GND_{Driver} via a third input node (31), a ground voltage, GND, via a second ground node (33), a second control signal, OFF1, and a third control signal, OFF2, and being further configured for outputting, GND_{Driver}, to a second output node (35) in dependence of the second and third control signals,
a switch controller (50) connected, via a first node, to the first output node (15) and, via a second node, to the second output node (35) and a gate node (151) of the solid state switch (150) and configured for receiving a ground voltage, GND, via a third ground node (53), and a fourth control signal, ON1, and being further configured for connecting the first output node (15) and the second node in dependence of the fourth control signal.

2. Solid state switch, SSS, driver circuit (100) of claim 1, wherein the voltage generation circuit (10) comprises a first capacitor (16) with a first capacitor node (161) connected to the first input node (11) via a first diode (17) and with a second capacitor node (162) connected to either the first ground node (13) or to the second input node (12) in dependence of the first control signal.

3. Solid state switch, SSS, driver circuit (100) of claim 2, wherein the voltage generation circuit (10) comprises a first switch (18) configured to connect the second capacitor node (162) to the first ground node (13) in response to the first control signal having a first value and a second switch (19) configured to connected the second capacitor node (162) to the second input node (12) in response to the first control signal having a second value.

4. Solid state switch, SSS, driver circuit (100) of any one of the preceding claims, wherein the voltage generation circuit (10) comprises a Zener diode (20) interconnected in parallel to the first capacitor (16) in between first output node (15) and second input node (12) and/or comprises a second capacitor (21) interconnected in parallel to the first capacitor (16) in between first output node (15) and second input node (12).

5. Solid state switch, SSS, driver circuit (100) of any one of the preceding claims, wherein the switch controller (50) comprises a third switch (51) configured to connect the first output node (15) to the gate node (151) in response to the fourth control signal having a first value and to disconnect the first output node (15) from the gate node (151) in response to the fourth control signal having a second value, wherein the second output (35) node is directly connected to the gate node (151).

6. Solid state switch, SSS, driver circuit (100) of claim 5, wherein the third switch (51) is a third MOSFET, T₃, with a source node connected to the first output node (15) and a drain node connected to the second output node (35) and wherein the switch controller (50) further comprises a fourth switch (52) that is configured to connect a gate node of the third MOSFET (51) to the third ground node (53) in response to the fourth control signal having a first value and to disconnect the gate node of the third MOSFET (51) from the third ground node (53) in response to the fourth control signal having a second value.

7. Solid state switch, SSS, driver circuit (100) of any one of the preceding claims, wherein the switch off circuit (30) comprises a fifth switch (36) configured to connect the third input node (31) to the second output node (35) in response to the second control signal having a first value and to disconnect the third input node (31) from the second output node (35) in response to the second control signal having a second value, and wherein the switch off circuit (30) comprises a seventh switch (37) configured to connect the third input node (31) to the second output node (35) in response to the third control signal having a first value and to disconnect the third input node (31) from the second output node (35) in response to the third control signal having a second value.

8. Solid state switch, SSS, driver circuit (100) of claim 7, wherein the fifth switch (36) is a fifth MOSFET, T₅, with a source node connected to the second output node (35) and a drain node connected to the third input node (31) and wherein the switch off circuit (30) further comprises a sixth switch (38) that is configured to connect a gate node of the fifth MOSFET (36) to the second ground node (33) in response to the second control signal having a first value and to disconnect the gate node of the fifth MOSFET (36) from the second ground node (33) in response to the second control signal having a second value.

9. Solid state switch, SSS, driver circuit (100) of claim 7 or 8, wherein the seventh switch (37) is a seventh MOSFET, T₇, with a source node connected to the second output node (35) and a drain node connected to the third input node (31) and wherein the switch off circuit (30) further comprises an eighth switch (39) that is configured to connect a gate node of the seventh MOSFET (37) to the second ground node (33) in response to the third control signal having a first value and to disconnect the gate node of the seventh MOSFET (37) from the second ground node (33) in response to the third control signal having a second value.

10. Solid state switch, SSS, driver circuit (100) of any one of the preceding claims, further comprising a first diagnostic circuit (60) configured to output a first diagnostic signal, DIAG₁, indicating a potential at the second input node (12) and to output a second diagnostic signal, DIAG2, indicating a potential at the first output node (15).

11. Solid state switch, SSS, driver circuit (100) of any one of the preceding claims, further comprising a second diagnostic circuit (70) configured to output a third diagnostic signal, DIAG₃, indicating a potential at the second output node (35).

12. A battery system (200), comprising
a battery cell stack comprising a plurality of battery cells and being configured for supplying an output voltage, GND_{Driver}, to a stack node (201);
a solid state switch, SSS, (150) interconnected between the stack node (201) and a supply node (202) and comprising at least one set of anti-serially interconnected FETs, each set comprising at least one first FET, T_{A}, (203) and at least one second FET, T_{B}, (204) wherein gate contacts of the FETs (203, 204) are electrically interconnected, source contacts of the FETs (203, 204) are electrically interconnected, at least one first drain contact of the at least one first FET (203) is electrically connected to the stack node (201), and at least one second drain contact of the at least one second FET (204) is electrically connected to the supply node (202); and
the solid state switch driver circuit (100) according to any one of claims 1 to 11, wherein the interconnected gate contacts of the FETs (203, 204) are connected to the gate node (151).

13. Battery system (200) of claim 12, wherein the supply voltage, V_{SUP}, is supplied by the battery cell stack, preferably by a system basis chip of the battery system (200) that is power supplied by the battery cell stack.

14. Battery system (200) of claim 11 or 12, further comprising a microcontroller configured to receive at least one signal indicative of an operation state of the battery system (200) and further configured to output the first control signal, the second control signal and the third control signal in dependence of the operation state of the battery system (200).

15. Battery system (200) of claim 14, wherein the microcontroller is further configured to receive the first diagnostic signal, the second diagnostic signal, and the third diagnostic signal.

## Patentansprüche

1. Festkörperschalter, SSS,-Treiberschaltung (100) zur Steuerung eines Festkörperschalters (150), der als High-Side-Schalter zwischen einem Batteriezellenstapel und einer Last betrieben wird, aufweisend:
eine Spannungserzeugungsschaltung (10), die konfiguriert ist, um eine Versorgungsspannung, V_{SUP}, über einen ersten Eingangsknoten (11), eine Ausgangsspannung des Batteriezellenstapels, GND_{Driver}, über einen zweiten Eingangsknoten (12), eine Massespannung, GND, über einen ersten Masseknoten (13) und ein erstes Steuersignal, PWM, zu erhalten, und die konfiguriert ist, um in Abhängigkeit vom ersten Steuersignal eine Treiberspannung, VCC_{Driver}, die höher als V_{SUP} und GND_{Driver} ist, zu erzeugen und um die VCC_{Driver} an einen ersten Ausgangsknoten (15) auszugeben,
eine Ausschaltschaltung (30), die konfiguriert ist, um die Ausgangsspannung GND_{Driver} über einen dritten Eingangsknoten (31), eine Massespannung, GND, über einen zweiten Masseknoten (33), ein zweites Steuersignal, OFF1, und ein drittes Steuersignal, OFF2, zu erhalten, und ferner konfiguriert ist, um in Abhängigkeit vom zweiten und dritten Steuersignal GND_{Driver} an einen zweiten Ausgangsknoten (35) auszugeben,
eine Schaltersteuerung (50), die über einen ersten Knoten mit dem ersten Ausgangsknoten (15) und über einen zweiten Knoten mit dem zweiten Ausgangsknoten (35) und einem Gate-Knoten (151) des Festkörperschalters (150) verbunden ist und konfiguriert ist, um eine Massespannung, GND, über einen dritten Masseknoten (53) und ein viertes Steuersignal, ON1, zu erhalten, und die ferner konfiguriert ist, um in Abhängigkeit vom vierten Steuersignal den ersten Ausgangsknoten (15) und den zweiten Knoten zu verbinden.

2. Festkörperschalter, SSS,-Treiberschaltung (100) nach Anspruch 1, wobei die Spannungserzeugungsschaltung (10) einen ersten Kondensator (16) aufweist, der einen ersten Kondensatorknoten (161), der über eine erste Diode (17) mit dem ersten Eingangsknoten (11) verbunden ist, aufweist und einen zweiten Kondensatorknoten (162), der in Abhängigkeit vom ersten Steuersignal entweder mit dem ersten Masseknoten (13) oder mit dem zweiten Eingangsknoten (12) verbunden ist, aufweist.

3. Festkörperschalter, SSS,-Treiberschaltung (100) nach Anspruch 2, wobei die Spannungserzeugungsschaltung (10) einen ersten Schalter (18), der konfiguriert ist, um in Reaktion darauf, dass das erste Steuersignal einen ersten Wert aufweist, den zweiten Kondensatorknoten (162) mit dem ersten Masseknoten (13) zu verbinden, und einen zweiten Schalter (19), der konfiguriert ist, um in Reaktion darauf, dass das erste Steuersignal einen zweiten Wert aufweist, den zweiten Kondensatorknoten (162) mit dem zweiten Eingangsknoten (12) zu verbinden, aufweist.

4. Festkörperschalter, SSS,-Treiberschaltung (100) nach einem der vorhergehenden Ansprüche, wobei die Spannungserzeugungsschaltung (10) eine Zener-Diode (20), die zwischen dem ersten Ausgangsknoten (15) und dem zweiten Eingangsknoten (12) mit dem ersten Kondensator (16) parallel geschaltet ist, aufweist und/oder einen zweiten Kondensator (21), der zwischen dem ersten Ausgangsknoten (15) und dem zweiten Eingangsknoten (12) mit dem ersten Kondensator (16) parallel geschaltet ist, aufweist.

5. Festkörperschalter, SSS,-Treiberschaltung (100) nach einem der vorhergehenden Ansprüche, wobei die Schaltersteuerung (50) einen dritten Schalter (51) aufweist, der konfiguriert ist, um in Reaktion darauf, dass das vierte Steuersignal einen ersten Wert aufweist, den ersten Ausgangsknoten (15) mit dem Gate-Knoten (151) zu verbinden und um in Reaktion darauf, dass das vierte Steuersignal einen zweiten Wert aufweist, den ersten Ausgangsknoten (15) vom Gate-Knoten (151) zu trennen, wobei der zweite Ausgangsknoten (35) mit dem Gate-Knoten (151) direkt verbunden ist.

6. Festkörperschalter, SSS,-Treiberschaltung (100) nach Anspruch 5, wobei der dritte Schalter (51) ein dritter MOSFET, T₃ ist, der einen Source-Knoten, der mit dem ersten Ausgangsknoten (15) verbunden ist, und einen Drain-Knoten, der mit dem zweiten Ausgangsknoten (35) verbunden ist, aufweist, und wobei die Schaltersteuerung (50) ferner einen vierten Schalter (52) aufweist, der konfiguriert ist, um in Reaktion darauf, dass das vierte Steuersignal einen ersten Wert aufweist, einen Gate-Knoten des dritten MOSFET (51) mit dem dritten Masseknoten (53) zu verbinden und um in Reaktion darauf, dass das vierte Steuersignal einen zweiten Wert aufweist, den Gate-Knoten des dritten MOSFET (51) vom dritten Masseknoten (53) zu trennen.

7. Festkörperschalter, SSS,-Treiberschaltung (100) nach einem der vorhergehenden Ansprüche, wobei die Ausschaltschaltung (30) einen fünften Schalter (36) aufweist, der konfiguriert ist, um in Reaktion darauf, dass das zweite Steuersignal einen ersten Wert aufweist, den dritten Eingangsknoten (31) mit dem zweiten Ausgangsknoten (35) zu verbinden und um in Reaktion darauf, dass das zweite Steuersignal einen zweiten Wert aufweist, den dritten Eingangsknoten (31) vom zweiten Ausgangsknoten (35) zu trennen, und wobei die Ausschaltschaltung (30) einen siebten Schalter (37) aufweist, der konfiguriert ist, um in Reaktion darauf, dass das dritte Steuersignal einen ersten Wert aufweist, den dritten Eingangsknoten (31) mit dem zweiten Ausgangsknoten (35) zu verbinden und um in Reaktion darauf, dass das dritte Steuersignal einen zweiten Wert aufweist, den dritten Eingangsknoten (31) vom zweiten Ausgangsknoten (35) zu trennen.

8. Festkörperschalter, SSS,-Treiberschaltung (100) nach Anspruch 7, wobei der fünfte Schalter (36) ein fünfter MOSFET, T₅ ist, der einen Source-Knoten, der mit dem zweiten Ausgangsknoten (35) verbunden ist, und einen Drain-Knoten, der mit dem dritten Eingangsknoten (31) verbunden ist, aufweist, und wobei die Ausschaltschaltung (30) ferner einen sechsten Schalter (38) aufweist, der konfiguriert ist, um in Reaktion darauf, dass das zweite Steuersignal einen ersten Wert aufweist, einen Gate-Knoten des fünften MOSFET (36) mit dem zweiten Masseknoten (33) zu verbinden und um in Reaktion darauf, dass das zweite Steuersignal einen zweiten Wert aufweist, den Gate-Knoten des fünften MOSFET (36) vom zweiten Masseknoten (33) zu trennen.

9. Festkörperschalter, SSS,-Treiberschaltung (100) nach Anspruch 7 oder 8, wobei der siebte Schalter (37) ein siebter MOSFET, T₇ ist, der einen Source-Knoten, der mit dem zweiten Ausgangsknoten (35) verbunden ist, und einen Drain-Knoten, der mit dem dritten Eingangsknoten (31) verbunden ist, aufweist, und wobei die Ausschaltschaltung (30) ferner einen achten Schalter (39) aufweist, der konfiguriert ist, um in Reaktion darauf, dass das dritte Steuersignal einen ersten Wert aufweist, einen Gate-Knoten des siebten MOSFET (37) mit dem zweiten Masseknoten (33) zu verbinden und um in Reaktion darauf, dass das dritte Steuersignal einen zweiten Wert aufweist, den Gate-Knoten des siebten MOSFET (37) vom zweiten Masseknoten (33) zu trennen.

10. Festkörperschalter, SSS,-Treiberschaltung (100) nach einem der vorhergehenden Ansprüche, ferner aufweisend eine erste Diagnoseschaltung (60), die konfiguriert ist, um ein erstes Diagnosesignal, DIAG₁, das ein Potential am zweiten Eingangsknoten (12) anzeigt, auszugeben und um ein zweites Diagnosesignal, DIAG₂, das ein Potential am ersten Ausgangsknoten (15) anzeigt, auszugeben.

11. Festkörperschalter, SSS,-Treiberschaltung (100) nach einem der vorhergehenden Ansprüche, ferner aufweisend eine zweite Diagnoseschaltung (70), die konfiguriert ist, um ein drittes Diagnosesignal, DIAG₃, das ein Potential am zweiten Ausgangsknoten (35) anzeigt, auszugeben.

12. Ein Batteriesystem (200), aufweisend
einen Batteriezellenstapel, der eine Vielzahl von Batteriezellen aufweist und konfiguriert ist, um eine Ausgangsspannung, GND_{Driver} an einen Stapelknoten (201) zu liefern;
einen Festkörperschalter, SSS, (150), der zwischen den Stapelknoten (201) und einen Versorgungsknoten (202) geschaltet ist und zumindest einen Satz antiseriell geschalteter FETs aufweist, wobei jeder Satz zumindest einen ersten FET, T_{A}, (203) und zumindest einen zweiten FET, T_{B}, (204) aufweist, wobei Gate-Kontakte der FETs (203, 204) elektrisch miteinander verbunden sind, Source-Kontakte der FETs (203, 204) elektrisch miteinander verbunden sind, zumindest ein erster Drain-Kontakt des zumindest einen ersten FET (203) mit dem Stapelknoten (201) elektrisch verbunden ist und zumindest ein zweiter Drain-Kontakt des zumindest einen zweiten FET (204) mit dem Versorgungsknoten (202) elektrisch verbunden ist; und
die Festkörperschaltertreiberschaltung (100) nach einem der Ansprüche 1 bis 11, wobei die miteinander verbundenen Gate-Kontakte der FETs (203, 204) mit dem Gate-Knoten (151) verbunden sind.

13. Batteriesystem (200) nach Anspruch 12, wobei die Versorgungsspannung, V_{SUP}, vom Batteriezellenstapel, vorzugsweise von einem System-Basis-Chip des Batteriesystems (200), der vom Batteriezellenstapel mit Energie versorgt wird, geliefert wird.

14. Batteriesystem (200) nach Anspruch 11 oder 12, ferner aufweisend einen Mikrocontroller, der konfiguriert ist, um zumindest ein Signal, das einen Betriebszustand des Batteriesystems (200) anzeigt, zu empfangen, und ferner konfiguriert ist, um das erste Steuersignal, das zweite Steuersignal und das dritte Steuersignal in Abhängigkeit vom Betriebszustand des Batteriesystems (200) auszugeben.

15. Batteriesystem (200) nach Anspruch 14, wobei der Mikrocontroller ferner konfiguriert ist, um das erste Diagnosesignal, das zweite Diagnosesignal und das dritte Diagnosesignal zu empfangen.

## Revendications

1. Circuit d'attaque d'interrupteur à semi-conducteurs, SSS *(solid state switch),* (100), destiné à commander un interrupteur à semi-conducteurs (150) utilisé comme interrupteur côté haut entre un empilement d'éléments de batterie et une charge, comprenant :
un circuit de génération de tension (10) configuré pour recevoir une tension d'alimentation, V_{SUP}, par l'intermédiaire d'un premier nœud d'entrée (11), une tension de sortie de l'empilement d'éléments de batterie, GND_{Driver}, par l'intermédiaire d'un deuxième nœud d'entrée (12), une tension de masse, GND, par l'intermédiaire d'un premier nœud de masse (13) et un premier signal de commande, PWM, et étant configuré pour générer une tension d'attaque, VCC_{Driver}, supérieure à V_{SUP} et GND_{Driver} en fonction du premier signal de commande et pour délivrer en sortie VCC_{Driver} à un premier nœud de sortie (15),
un circuit de mise hors tension (30) configuré pour recevoir la tension de sortie GND_{Driver} par l'intermédiaire d'un troisième nœud d'entrée (31), une tension de masse, GND, par l'intermédiaire d'un deuxième nœud de masse (33), un deuxième signal de commande, OFF1, et un troisième signal de commande, OFF2, et étant configuré en outre pour délivrer en sortie GND_{Driver} à un second nœud de sortie (35) en fonction des deuxième et troisième signaux de commande,
un contrôleur d'interrupteur (50) connecté, par l'intermédiaire d'un premier nœud, au premier nœud de sortie (15), et par l'intermédiaire d'un second nœud, au second nœud de sortie (35) et à un nœud de grille (151) de l'interrupteur à semi-conducteurs (150) et configuré pour recevoir une tension de masse, GND, par l'intermédiaire d'un troisième nœud de masse (53), et un quatrième signal de commande, ON1, et étant configuré en outre pour connecter le premier nœud de sortie (15) et le second nœud en fonction du quatrième signal de commande.

2. Circuit d'attaque d'interrupteur à semi-conducteurs, SSS, (100) selon la revendication 1, dans lequel le circuit de génération de tension (10) comprend un premier condensateur (16) doté d'un premier nœud de condensateur (161) connecté au premier nœud d'entrée (11) par l'intermédiaire d'une première diode (17), et d'un second nœud de condensateur (162) connecté soit au premier nœud de masse (13) soit au deuxième nœud d'entrée (12) en fonction du premier signal de commande.

3. Circuit d'attaque d'interrupteur à semi-conducteurs, SSS, (100) selon la revendication 2, dans lequel le circuit de génération de tension (10) comprend un premier interrupteur (18) configuré pour connecter le second nœud de condensateur (162) au premier nœud de masse (13) en réponse au fait que le premier signal de commande a une première valeur, et un second interrupteur (19) configuré pour connecter le second nœud de condensateur (162) au deuxième nœud d'entrée (12) en réponse au fait que le premier signal de commande a une seconde valeur.

4. Circuit d'attaque d'interrupteur à semi-conducteurs, SSS, (100) selon l'une quelconque des revendications précédentes, dans lequel le circuit de génération de tension (10) comprend une diode Zener (20) interconnectée en parallèle au premier condensateur (16) entre le premier nœud de sortie (15) et le deuxième nœud d'entrée (12) et/ou comprend un second condensateur (21) interconnecté en parallèle au premier condensateur (16) entre le premier nœud de sortie (15) et le deuxième nœud d'entrée (12).

5. Circuit d'attaque d'interrupteur à semi-conducteurs, SSS, (100) selon l'une quelconque des revendications précédentes, dans lequel le contrôleur d'interrupteur (50) comprend un troisième interrupteur (51) configuré pour connecter le premier nœud de sortie (15) au nœud de grille (151) en réponse au fait que le quatrième signal de commande a une première valeur et pour déconnecter le premier nœud de sortie (15) du nœud de grille (151) en réponse au fait que le quatrième signal de commande a une seconde valeur, dans lequel le second nœud de sortie (35) est directement connecté au nœud de grille (151).

6. Circuit d'attaque d'interrupteur à semi-conducteurs, SSS, (100) selon la revendication 5, dans lequel le troisième interrupteur (51) est un troisième transistor MOSFET, T₃, doté d'un nœud de source connecté au premier nœud de sortie (15) et d'un nœud de drain connecté au second nœud de sortie (35) et dans lequel le contrôleur d'interrupteur (50) comprend en outre un quatrième interrupteur (52) qui est configuré pour connecter un nœud de grille du troisième transistor MOSFET (51) au troisième nœud de masse (53) en réponse au fait que le quatrième signal de commande a une première valeur et pour déconnecter du troisième nœud de masse (53) le nœud de grille du troisième transistor MOSFET (51) en réponse au fait que le quatrième signal de commande a une seconde valeur.

7. Circuit d'attaque d'interrupteur à semi-conducteurs, SSS, (100) selon l'une quelconque des revendications précédentes, dans lequel le circuit de mise hors tension (30) comprend un cinquième interrupteur (36) configuré pour connecter le troisième nœud d'entrée (31) au second nœud de sortie (35) en réponse au fait que le deuxième signal de commande a une première valeur et pour déconnecter le troisième nœud d'entrée (31) du second nœud de sortie (35) en réponse au fait que le deuxième signal de commande a une seconde valeur, et dans lequel le circuit de mise hors tension (30) comprend un septième interrupteur (37) configuré pour connecter le troisième nœud d'entrée (31) au second nœud de sortie (35) en réponse au fait que le troisième signal de commande a une première valeur et pour déconnecter le troisième nœud d'entrée (31) du second nœud de sortie (35) en réponse au fait que le troisième signal de commande a une seconde valeur.

8. Circuit d'attaque d'interrupteur à semi-conducteurs, SSS, (100) selon la revendication 7, dans lequel le cinquième interrupteur (36) est un cinquième transistor MOSFET, T₅, doté d'un nœud de source connecté au second nœud de sortie (35) et d'un nœud de drain connecté au troisième nœud d'entrée (31) et dans lequel le circuit de mise hors tension (30) comprend en outre un sixième interrupteur (38) qui est configuré pour connecter un nœud de grille du cinquième transistor MOSFET (36) au deuxième nœud de masse (33) en réponse au fait que le deuxième signal de commande a une première valeur et pour déconnecter du deuxième nœud de masse (33) le nœud de grille du cinquième transistor MOSFET (36) en réponse au fait que le deuxième signal de commande a une seconde valeur.

9. Circuit d'attaque d'interrupteur à semi-conducteurs, SSS, (100) selon la revendication 7 ou 8, dans lequel le septième interrupteur (37) est un septième transistor MOSFET, T₇, doté d'un nœud de source connecté au second nœud de sortie (35) et d'un nœud de drain connecté au troisième nœud d'entrée (31) et dans lequel le circuit de mise hors tension (30) comprend en outre un huitième interrupteur (39) qui est configuré pour connecter un nœud de grille du septième transistor MOSFET (37) au deuxième nœud de masse (33) en réponse au fait que le troisième signal de commande a une première valeur et pour déconnecter du deuxième nœud de masse (33) le nœud de grille du septième transistor MOSFET (37) en réponse au fait que le troisième signal de commande a une seconde valeur.

10. Circuit d'attaque d'interrupteur à semi-conducteurs, SSS, (100) selon l'une quelconque des revendications précédentes, comprenant en outre un premier circuit de diagnostic (60) configuré pour délivrer en sortie un premier signal de diagnostic, DIAG₁, indiquant un potentiel au niveau du deuxième nœud d'entrée (12) et pour délivrer en sortie un deuxième signal de diagnostic, DIAG2, indiquant un potentiel au niveau du premier nœud de sortie (15).

11. Circuit d'attaque d'interrupteur à semi-conducteurs, SSS, (100) selon l'une quelconque des revendications précédentes, comprenant en outre un deuxième circuit de diagnostic (70) configuré pour délivrer en sortie un troisième signal de diagnostic, DIAG₃, indiquant un potentiel au niveau du second nœud de sortie (35).

12. Système de batterie (200) comprenant :
un empilement d'éléments de batterie comprenant une pluralité d'éléments de batterie et étant configuré pour fournir une tension de sortie, GND_{Driver}, à un nœud d'empilement (201) ;
un interrupteur à semi-conducteurs, SSS, (150) interconnecté entre le nœud d'empilement (201) et un nœud d'alimentation (202) et comprenant au moins un ensemble de transistors FET interconnectés en anti-série, chaque ensemble comprenant au moins un premier transistor FET, T_{A}, (203) et au moins un second transistor FET, T_{B}, (204), où les contacts de grille des transistors FET (203, 204) sont interconnectés électriquement, les contacts de source des transistors FET (203, 204) sont interconnectés électriquement, au moins un premier contact de drain de l'au moins un premier transistor FET (203) est électriquement connecté au nœud d'empilement (201), et au moins un second contact de drain de l'au moins un second transistor FET (204) est électriquement connecté au nœud d'alimentation (202) ; et
le circuit d'attaque d'interrupteur à semi-conducteurs (100) selon l'une quelconque des revendications 1 à 11, où les contacts de grille interconnectés des transistors FET (203, 204) sont connectés au nœud de grille (151).

13. Système de batterie (200) selon la revendication 12, dans lequel la tension d'alimentation, V_{SUP}, est fournie par l'empilement d'éléments de batterie, de préférence par une puce de base de système du système de batterie (200), qui est alimentée en énergie par l'empilement d'éléments de batterie.

14. Système de batterie (200) selon la revendication 11 ou 12, comprenant en outre un microcontrôleur configuré pour recevoir au moins un signal indiquant un état de fonctionnement du système de batterie (200), et configuré en outre pour délivrer en sortie le premier signal de commande, le deuxième signal de commande et le troisième signal de commande en fonction de l'état de fonctionnement du système de batterie (200).

15. Système de batterie (200) selon la revendication 14, dans lequel le microcontrôleur est configuré en outre pour recevoir le premier signal de diagnostic, le deuxième signal de diagnostic et le troisième signal de diagnostic.
